# EUROPEAN PATENT APPLICATION

(11) **EP 4 443 243 A1**
(43) Date of publication of application: **09.10.2024**
(21) Application number: 23166686.8
(22) Date of filing: 05.04.2023
(51) Int. Cl.: G03F 7/20, B41M 1/04

(54) **PROCESS AND SYSTEM FOR MINIMIZING PLATE DEFORMATION IN THE SOLVENT MINIMIZED MANUFACTURE OF A PRINTING PLATE**

(71) Applicant: Esko-Graphics Imaging GmbH, 25524 Itzehoe (DE)
(72) Inventor: Arlt, Klaus, CH-8105 Regensdorf (CH); Anthoons, Jonathan, CH-8105 Regensdorf (CH)
(74) Representative: Jonas, Hans-Hermann

(57) **Abstract**

Systems and processes for creating a fully developed photopolymer printing plate from a plate precursor. One or more areas of cured polymer, optionally defining one or more solid cells and one or more discontinuities in or between the one or more solid cells in a defined pattern, are created covering a majority of one or more defined non-printing waste areas. The cells have a cell surface area of less than or equal to a predefined value, and the discontinuities have a discontinuity width less than or equal to a predefined value. A size for the one or more cells, a size for the one or more discontinuities, a pattern type for the one or more discontinuities, or a combination thereof may be variables selected by a user via a user interface of a system for performing the process.

## Description

### BACKGROUND OF THE INVENTION

As is well known in the field of making flexographic printing plates, one process of manufacturing a plate ready for printing typically starts with a plate precursor comprising a photopolymer. A mask or masking layer, such as a Laser Ablated Mask (LAMS) layer, is disposed over the photopolymer to block actinic radiation from curing the photopolymer. Openings in the mask are created corresponding to the image to be printed, which openings permit actinic radiation to penetrate the mask during an exposure step to cause curing (crosslinking) of the photopolymer in the exposed areas. Unexposed (uncrosslinked) areas are later removed in a developing step. Exemplary developing steps are performed by solvent-or water-based development systems, in which a washing step dissolves and removes the uncured polymer, or thermal development systems in which heat melts away the uncured polymer. After a washing step, the plate is typically dried, and may be subject to further finishing exposure steps to form a fully developed plate. That fully developed plate may be used whole in printing processes, or in the case of a plate imaged with patches of smaller plates for end use, may be cut with a cutter to separate the patches from one another and from any other waste areas of the plate.

Notably, water washing is technically a subset of solvent washing systems, in which water is the solvent. Traditionally, the term "solvent" when used for referring to solvent-based development systems refers to use of any one of a number of hydrocarbon-based solvents known in the art. Certain photopolymer systems or plate constructions may have specific solvents associated therewith, which use a solvent other than water, which solvent is typically a mixture of components including at least one hydrocarbon. Technically, the term "solvent" may refer to water-based development systems in which water is the solvent as well as to non-water-based development systems, as the term is more traditionally used.

A typical flexographic (flexo) printing plate workflow may thus comprise the following steps:
1. Processing image information, using a raster image processor, at a certain screen resolution to obtain an image file.
2. Optionally, using the processor, combining the image file with other image files to create an imaging job that covers a full polymer plate format.
3. Imaging the image file(s) onto a Laser Ablation Mask (LAM) layer on top of a photopolymer printing plate precursor, by any of various methods known in the art, thereby creating a mask on top of the in-process plate precursor.
4. Curing the rear side of the in-process plate precursor, such as with UVA light, to build a floor of polymer.
5. Curing the photopolymer through the mask on top of the in-process plate precursor, such as with UVA light.
6. Processing the in-process plate precursor to remove non-cured polymer from the in-process plate precursor.
7. Optionally, drying the plate to remove solvent (when the developing includes a solvent or water washing process).
8. Finishing the in-process plate precursor, such as by applying UVA and UVC light.
9. Optionally, for fully developed plates in which a plurality of plate patches each correspond to different image files, separating the patches, such as by cutting the fully developed plate into patches on a xy-cutting table.
10. Optionally, when patches are used, mounting one or more of the print-ready plate patches, each of which embodies one or more image files, on a printing press, such as on a printing press cylinder.
11. Printing physical images on a print-receiving substrate using the finished plate or plate patch in a printing press.

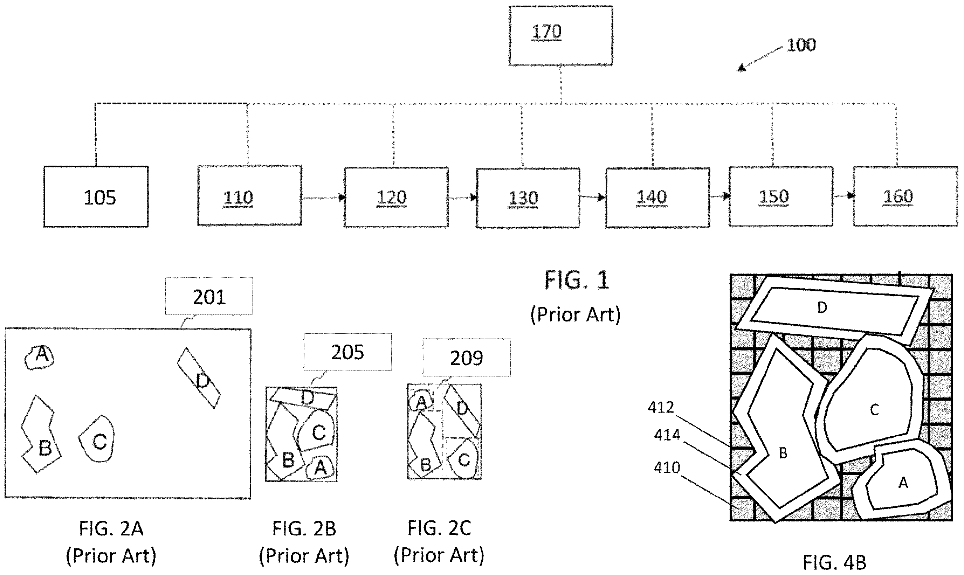

Fig. 1 schematically illustrates a workflow 100 having a plurality of process machines 105, 110, 120, etc., each configured to perform one or more process steps in the workflow of creating a finished printing plate, as described above. The imaging step is performed by an imager 105; the exposure step is performed by an (e.g. UV) exposure system 110; a thermal or chemical development step is performed by thermal or chemical processing apparatus 120 to remove uncured polymer; a finishing step is performed by finishing apparatus 130; an optional cutting step is performed by cutting apparatus 140, followed by mounting one or more cut portions of a fully developed plate onto a substrate with a mounting apparatus 150; and printing in a flexo process is performed with a printer 160 using the plate-ready printing plate (or, for printing with plate patches, using the carrier sheet having the plate portions mounted therein). Additional steps may also be included in the workflow at the beginning or end, and interposed between any of the steps specifically depicted. The blocks associated with each processing step are exemplary only, and a single machine may perform steps related to multiple blocks, or multiple machines may together perform the steps illustrated in a single block. Some steps depicted may be optional. As is known in the art, input image information is typically processed by a raster image processor (RIP) into digital data used for creating the openings in the masking layer. RIPping and imaging are typically provided to a computer processor associated with the imager by a data file as part of or prior to step 105.

As noted above, it is often desired to create a number of small plate "patches" from a larger printing plate precursor, typically in order to minimize plate waste. For example, U.S. Patent No. 6,954,291, titled "METHOD, APPARATUS, AND COMPUTER PROGRAM FOR REDUCING PLATE MATERIAL WASTE IN FLEXOGRAPHY PLATE MAKING," owned by the assignee of the present invention and incorporated herein by reference, describes a method for reducing plate material waste in flexography plate making by which full-format screened data is processed in a computer-implemented method to identify zones (e.g. A, B, C, D in area 201 of Fig. 2A) that contain printable information. The zones are packed (e.g. in a free-form manner as shown in area 205 of FIG. 2B, or with bounding-boxes as shown in area 209 of FIG. 2C), imaged, and made into fully-developed plates, and elements cut out from the fully-developed plates for each zone of printable information. The cut elements are then later placed on a carrier to form a set of plates on a carrier for printing the full format screened data. The print-ready plate patches mounted on a carrier sheet made thereby use less flexo material than if the full-format screened data were to be fabricated on a single large plate, with large areas of non-printing areas.

Empty spaces on the printing plate that do not contain a printing patch, such as areas between the patches, or a border between the edges of the plate precursor and a patch layout area, are waste. While there are a number of ways to minimize that waste, it is not entirely unavoidable. Without limitation, there may be any number of reasons that certain areas of a plate precursor are identified prior to creation of the finished plate as areas where at least a portion of the plate will be cut away as waste, including but not limited to a border area.

In solvent- or water-washing development systems, greater amounts of empty space on the plate (e.g. between patches or between the patch layout area and the edges of the plate) use greater amounts of solvent or water to remove the uncured polymer from those spaces during the development step. Likewise, more solvent used during development leads to more used solvent to be recovered (e.g. by distillation systems) or treated (e.g. in wastewater treatment and/or filtration systems) in optional steps downstream of the development step.

Accordingly, it may be beneficial to reduce the amount of empty space on the plate in order to reduce solvent waste

### SUMMARY OF THE INVENTION

One aspect of the invention relates to a process for creating a fully-developed photopolymer printing plate from a photopolymer printing plate precursor. The process includes defining one or more non-printing waste areas of the plate precursor and creating one or more areas of cured polymer covering a majority of the one or more non-printing waste areas. The cured polymer has a height extending above a floor of the fully-developed plate to a printing level. In preferred embodiments, the one or more cured areas comprise one or more solid cells of cured polymer and one or more discontinuities in or between the one or more solid cells of cured polymer in a defined pattern, wherein the one or more discontinuities have a height less than the printing level. Each of the one or more cells of cured polymer in the one or more non-printing waste regions has a cell surface area of less than or equal to a predefined value, and each of the one or more discontinuities has a discontinuity width less than or equal to a predefined value. A size for the one or more cells, a size for the one or more discontinuities, a pattern type for the one or more discontinuities, or a combination thereof may be variables selected by a user via a user interface of a system for performing the process.

The one or more discontinuities may define a grid of intersecting lines with rectangular cells defined therebetween, each rectangular cell having a first lateral dimension and a second lateral dimension, wherein the first lateral dimension and the second lateral dimension are user-selected variables. The plate precursor may include an image area of the plate surrounded by a border area that extends from outer edges of the image area to lateral edges of the plate, in which case the one or more non-printing waste areas may be defined in the border region of the plate. In embodiments, the image area defines a plurality of plate patches to be cut from the fully developed photopolymer printing plate, and one or more non-patch areas between adjacent patches in the plurality of plate patches, wherein the one or more non-printing waste areas are defined in the one or more non-patch areas between the adjacent patches in the plurality of plate patches.

The predefined value for the cell surface area and the predefined value for the discontinuity width are selected to reduce usage of solvent (especially a non-water-based solvent, such as a hydrocarbon solvent) in an uncured polymer removal step and to minimize deformation of the photopolymer printing plate precursor during a processing step (such as a drying step) performed after the uncured polymer removal step.

Another aspect of the invention relates to a system for creating a fully developed photopolymer printing plate from a photopolymer printing plate precursor having a masking layer, the masking layer configured to block actinic radiation from exposing and curing the photopolymer. The system comprises an imaging system configured to define openings in the masking layer, each opening configured to permit penetration of actinic radiation. The imaging system is configured to define an image area of the photopolymer printing plate precursor having openings in the masking layer corresponding to an image to be printed, to define one or more non-printing waste areas of the photopolymer printing plate precursor, and then to apply in the one or more defined non-printing waste areas a pattern of openings in the masking layer in a majority of the one or more waste areas corresponding to one or more areas of cured polymer having a height extending above a floor of the fully-developed plate to a printing level. In embodiments, the one or more areas of cured polymer define one or more solid cells of cured polymer with one or more discontinuities in or between the one or more solid cells of cured polymer in the one or more non-printing waste regions. The cells of cured polymer in the one or more non-printing waste regions have a height at the printing level and the one or more discontinuities have a height below the printing level. The system may further include a computer memory, one or more processors configured to execute instructions stored in the computer memory, and a user interface connected to the computer memory for receiving input from a user, the user input including cell and discontinuity information comprising a size for the one or more cells, a size for the one or more discontinuities, a pattern type for the discontinuities, or a combination thereof. The user interface may be, for example, configured to permit a user to select a grid pattern type, a maximum grid cell width, a maximum grid cell length, and a grid cell gap. The one or more processors may include a raster image processor (RIP) and the user interface may be configured to provide the cell and discontinuity user input information to image information subsequently processed by the RIP.

In embodiments, the system may be configured to define a plurality of plate patches to be cut from the fully developed photopolymer printing plate in the image area, and one or more non-patch areas between adjacent patches in the plurality of plate patches, with the one or more non-printing waste areas defined in the one or more non-patch areas between the adjacent patches in the plurality of plate patches. In embodiments, the system may be configured to define an image area of the plate surrounded by a border area that extends from outer edges of the image area to lateral edges of the plate, wherein the one or more non-printing waste areas are defined in the border region of the plate.

Yet another aspect of the invention relates to non-transitory computer media programmed with machine-readable instructions readably by a processor of an imager in a system for creating a fully-developed photopolymer printing plate from a photopolymer printing plate precursor having a masking layer configured to block actinic radiation from contacting and curing the photopolymer. The imager is configured to define openings in the masking layer, each opening configured to permit penetration of actinic radiation. The instructions are configured to cause the imager (a) to define an image area of the photopolymer printing plate precursor having openings in the masking layer corresponding to an image to be printed, and (b) to define one or more non-printing waste areas of the photopolymer printing plate precursor and applying to a majority of the one or more waste areas a pattern comprising openings in the masking layer corresponding to one or more solid areas of cured polymer, optionally in the form of one or more solid cells of cured polymer and one or more discontinuities in or between the one or more solid cells of cured polymer. The areas of cured polymer (e.g. the optional solid cells) in the one or more non-printing waste regions have a height extending above a floor of plate to a printing level of the fully-developed plate and the optional one or more discontinuities have a height below the printing level. The machine readable instructions optionally include instructions for causing a user interface connected to the computer memory to receive input from a user, the user input including a size for the one or more cells, a size for the one or more discontinuities, a pattern type for the discontinuities, or a combination thereof.

### BRIEF DESCRIPTION OF THE DRAWINGS

FIG. 1 depicts an exemplary workflow for creating a printing plate
FIG. 2A depicts a collection of zones to be formed as plate patches.
FIG. 2B depicts an exemplary "free-form" packing arrangement of the plate patches corresponding to the zones of FIG. 2A on an exemplary plate.
FIG. 2C depicts an exemplary "bounding box" packing arrangement of the plate patches corresponding to the zones of FIG. 2A on an exemplary plate.
Fig. 3 depicts a plate or plate patch defining an image area for printing, and a continuous solid area surrounding the image area.
FIG. 4A depicts a plate or plate patch defining a similar image for printing as shown in FIG. 3, and an area bordering the image area a plurality of discontinuities separating a plurality of discrete solid areas.
FIG. 4B depicts a plate defining the "free-form" packing arrangement as shown in FIG. 2B, and areas between the patches including a plurality of discontinuities separating a plurality of discrete solid areas.
FIG. 5 is a photograph of a portion of a printing plate or plate patch marked by curling corresponding to a plate patch with a continuous solid border such as that depicted in FIG. 3.
FIG. 6 is a photograph of a portion of a printing plate or plate patch exhibiting minimal or no curling, corresponding to a plate patch with a discontinuous border such as that depicted in FIG. 4A.
FIG. 7 is a schematic illustration of an exemplary printing plate in cross-section.
FIG. 8 is a schematic illustration of an exemplary imaging system programmed to create the plate or plate patch of FIG. 4.

### DETAILED DESCRIPTION OF THE INVENTION

One embodiment for reducing the amount of empty space on a plate in order to minimize solvent waste includes adding solid areas to at least certain empty spaces on the photopolymer printing plate. A solid printing area (i.e. having cured polymer at a printing height of the plate), as compared to non-printing area (i.e. having little or no cured polymer above a floor level of the plate) in the empty space corresponds to an area of full exposure to the actinic radiation and full curing, leaving little to no uncured photopolymer to be dissolved by (and to thus consume) the solvent.

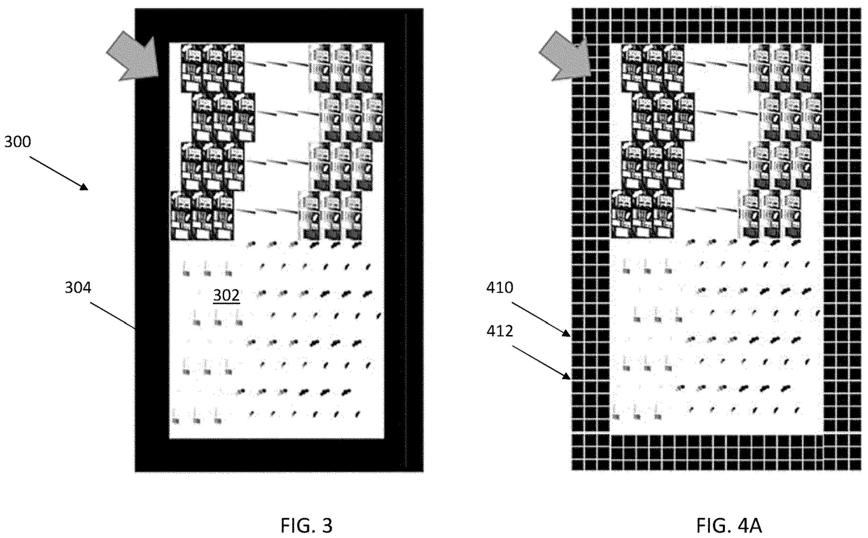

FIG. 3 illustrates a fully developed printing plate or print-ready patch 300 comprising an image area or patch layout area 302 in the center of the plate. The solid frame 304 around the area 302 designates plate area that ultimately will not be used and will be cut off after the plate has been fully developed. The solid frame depicted in FIG. 3, in accordance with an embodiment disclosed herein, forms an areas of fully cured polymer at the printing height of the printing plate, thus using the least amount of solvent possible. The fully cured empty space is later cut off, just as the non-fully-cured area of the frame is cut off in a system that does not utilize such solvent minimization technology.

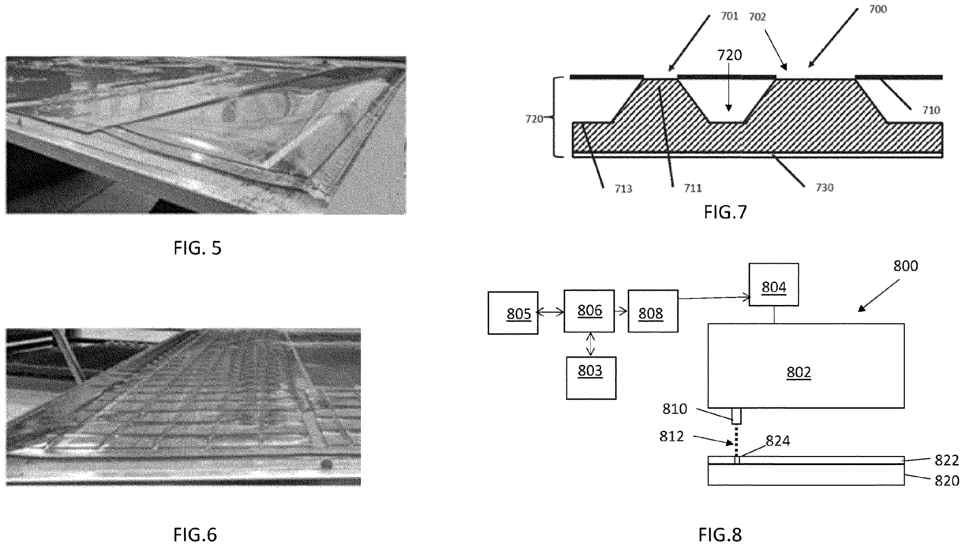

One problem with the foregoing approach, however, is that large solid areas on printing plates tend to cause deformation in the plate (i.e. curling). While not limited to any particular theory, it is believed that the curling of the plates is due to swelling of the plates when solvent migrates into the cured portions of the plate. This phenomenon is particularly pronounced with non-water-based (i.e. hydrocarbon) solvents, but is also present in water-based solvent systems. This migration is understood to typically occur only from the front (printing) side of the plate, and not from the back (non-printing side), such that the center point of the radius of curvature is typically on the rear side. Such deformation may, in turn, cause any number of problems, including but not limited to deformed portions of the plates touching undesired portions of downstream equipment (e.g. the border of the plate may touch the plate-drying equipment, which in turn may lead to uneven results also on the printing patch parts of the plate). An example of such plate deformation is depicted in the photo depicted in FIG. 5 showing a curled plate portion.

Accordingly, there is a benefit to not only minimize solvent waste, but also to at the same time to minimize plate deformation and the related problems .

In embodiments of the invention, deformation of the plate (e.g. curling) is avoided by introducing discontinuities into the previously solid waste areas, thus dividing the formerly large, interconnected, continuous border area depicted in FIG. 3, into many smaller non-connected areas or cells 410 separated by discontinuities or gaps 412, as shown in FIG. 4A. In one embodiment, a grid pattern of non-imaged lines in the LAMS layer resolve to gaps that divide the otherwise solid waste area into segments or cells.

As used herein, the term "printing plate precursor" refers to the initial printing plate "blank" prior to imaging, exposure, or development, the term "in-process plate" may be used to refer to the printing plate precursor after processing has started but has not been fully completed (although the term "printing plate precursor" may still be used in this context as well). The term "fully developed plate" refers to the printing plate after all developing and finishing steps, prior to any cutting steps. The term "finished plate" or "print-ready plate" refers to a full plate, or plate patch, that is in its final state and ready to be mounted on a carrier sheet (in the case of a patch), or on a printing press (in the case of a full plate) to receive and transfer ink. The terms "printing plate" or "plate" may also be used as shorthand to refer to the plate at any point in the process between precursor and print-ready plate. Although flexographic (flexo) plates are expressly discussed herein, aspects of the invention are not limited to any particular type of plate, and may be applicable to any type of printing plate polymer that involves curing and removal of uncured polymer. Although the actinic radiation as referenced herein relates primarily to UV radiation, as that is the common technology used in the printing field, the invention is not limited to any particular actinic radiation wavelength used for curing the polymer. Likewise, although the examples herein discuss imaging by laser ablating a LAMS masking layer, other mask imaging technologies (e.g. creation of a film-based mask that is then laminated to the photopolymer) are known and applicable to the invention as discussed herein.

In exemplary embodiments, software for manufacturing the plate (e.g. computer readable media programmed with instructions readable by a processor of an imager) may have settings for creating the segmented solid waste areas, which may have various settings for selecting the sizes of the solid cells and the gaps between the cells. In one embodiment, a grid may comprise 5 mm grooves separating 50 x 50 mm solid patches. It should be understood, however, that the invention is not limited to any particular size of the gaps or cells separated thereby, nor is the invention limited only to a regular grid pattern. And, even in a regular grid pattern, it should be understood that the cell size may represent a maximum cell size, as the dimensions of the waste areas are unlikely to align perfectly with whole cell sizes, and thus, at least some of the cells may have different dimensions than others of the cells, where space does not permit creation of full cells. While straight lines are preferred, the grooves may be straight or curved, such as in repeating regular curves (e.g. sine waves) or free-form, non-repeating curves. However, the greater the ratio of solid area to discontinuity area, the more solvent is saved, providing incentive to maximize the ratio.

While a grid may be a simple pattern to execute, any disposition of grooves that results in solid segments of a suitably minimal size to avoid plate deformation may be operable. Accordingly, the discontinuities may be linear on a horizontal / vertical grid relative to the edges of the plate or the plate patch, disposed on a diagonal grid with square or non-square intersections, and are preferably continuous themselves, but not limited thereto. Although not limited thereto, lines or grids having at least one component that is perpendicular to the transportation of the plate in the plate workflow are favored, as most of the observed curling is perpendicular to the transportation direction of the plate. The grooves preferably have a depth that reaches to the floor of the plate, although not limited thereto, but in any event, the height of the fully developed plate at the location of each groove or discontinuity is less than the printing level. The discontinuities may also define graphic or geometric patterns (e.g. circles, triangles, etc.) that are separated from other discontinuities by solid area. In particular, triangles may offer an advantage because of the component perpendicular to the transportation direction. In embodiments, the discontinuities may form alphanumeric text or a machine readable code, including proprietary source identifiers (e.g. trademarks or service marks, such as graphics, logos, or other marks or signs).

While minimizing the use of non-water solvents may have a greater financial incentive, the invention is not limited to use in non-water-solvent systems, as even the minimization of water in water washing systems has at least environment, if not also some cost, savings. While discussed expressly in the context of print patch embodiments and depicted with a rectangular border in FIG. 3, it should be understood that in many systems, the patches are intentionally packed in a manner that minimizes photopolymer plate waste, such that border areas are non-rectangular and non-uniform, such as in the areas between patches A, B, C, and D in plate example 205 depicted in FIG. 2B, which may result in the grouping and image areas as set forth in FIG. 4B. As depicted in FIG. 4B, each patch has a border area 414 of a predefined width that follows the contour of the patch, and the grid defined by the discontinuities remains in a fixed arrangement, regardless of the arrangement of the patches. In other embodiments, each area between the patches may contain cells and discontinuities tailored the size of the waste area for maximum effect. In embodiments that use bounding boxes, the patches are all generally rectangular in geometry, but the amount of space between the edge of the patch and the image area may be irregular.

FIG. 8 schematically illustrates an exemplary image-preparation and imaging system 800 for performing aspects of the invention. Imager 802 is configured to define openings 824 (e.g. by ablation with laser 810) in the masking layer 822 disposed over the photopolymer layer 820, each opening configured to permit penetration of actinic radiation (in an exposure step) to contact and cure the photopolymer 820. While only the LAMS layer and photopolymer layers of the plate are shown, it should be understood that additional plate layers are typically present, including, specifically a backing layer (not shown). The imaging system is configured to define the openings in the image area and in the one or more non-printing waste regions as discussed herein. The image-preparation portion of system 800 includes a computer memory 805, a processor 806 configured to execute instructions stored in the computer memory, and a user interface 803 connected to the processor for receiving input from a user (not shown) (which the processor may then convert to information stored in the memory). The user interface may be, for example, a keyboard or mouse connected to a display (not shown) that displays information visible to a human user, wherein the display depicts one or more input screens or menus, through which the user can interactively navigate. The user input may include areas of the display to which the user may direct a cursor and select from one or more choices, or enter a discrete value for, e.g., a size for the one or more solid areas, a size for the one or more discontinuities, a pattern type for the discontinuities, or a combination thereof. For example, the user may be able to specify a "grid" pattern type, a maximum grid cell width, a maximum grid cell length, and a grid cell gap width.

Processor 806 as depicted schematically herein is intended to represent any computers or processors configured to at least receive input image information create halftone images and separations (for different ink colors, such as CMYK) from an input image, applying screening techniques to the halftone image, and send the processed image information to a RIP 808 for RIPping the image into a digital form usable by the imager. Processor 806 may thus comprise a single processor a group of interconnected processors, as is known in the art. A controller 804 for the imager is configured for converting the RIPped information into instructions that cause the imager to apply laser pulses of specific intensity and duration applied at specific coordinates on the plate to create the mask openings corresponding to the image information. The processor 806 and controller 804, or other components connected thereto, may also be configured for receiving various other user input applied anywhere in the process from selecting the image to be converted to the printing plate through delivering corresponding image information to the imager in an imager-ready form..

Processing of the image information may thus include a user, via the user interface 803 connected to processor 806, selecting parameters for the solvent-saving, anti-plate-deformation features as discussed herein. In the case of a user selecting a grid pattern having specified cell and gap sizes, the processor then applies those parameters to the empty space on the image information sent to the RIP for ultimately imaging the plate. The processor determines an amount of space to be filled, and populates that space with the selected pattern. In the event the selected pattern is a regular pattern that does not precisely align within the space, the processor may be configured to truncate a portion of one or more of the cells. In one embodiment, the pattern to be applied to the empty spaces may be supplied as a screen. The processor may first identify waste areas, and then apply the screen to those waste areas, optionally by also including a border of predetermined size between the waste area and the image printing area(s) or patch layout area(s). Waste areas (which in the original image area would be designated as non-open areas in the mask that would not be cured) are first identified by the processor, then the screen is applied to the identified waste areas to populate those areas with as much of the screen pattern as overlaps the waste area, with portions of the cells and gaps truncated by the borders of the waste area. In another embodiment, the processor may identify the waste areas, including but not limited to border areas, and then apply a pattern (e.g. grid) of cells and discontinuities as described herein to the waste area, regardless of whether the resulting cells are all full sized or some are only partial size. In still other embodiments, the processor may define the waste area, and then generate a pattern specific to the waste area geometry, to maximize the solvent saved with minimized deformation in a bespoke pattern that maintains an optimal ratio of solid area to gap area. In any event, the solvent-saving, anti-plate-deformation features are typically applied to the image information by the processor prior to transmission of the image information to the RIP.

FIG. 7 depicts an exemplary cross-section of a waste area portion of a fully developed photopolymer printing plate 700, showing LAMs layer 710 for illustration only, as this layer is removed in the uncured polymer removal step. The plate has a (e.g. polyethylene) backing layer 730 and photo curable polymer 720 in between. Hatched portions depicted in FIG. 7 are those portions of the plate that have been cured through the mask openings 701 and 702 and the backing layer 730 and that will stay on the backing layer after LAMs and non-cured portions of polymer have been removed in the washing process. Actinic radiation (e.g. UV light) entering the plate through the backing layer forms the so-called floor 713 of the plate having a floor height above the substrate 730. The thickness (or height above substrate 730) of each structure is determined by the amount of light energy the polymer receives. At the places where mask openings 701, 702 are located, structures 711 grow from the floor to the top of the plate. Such structures may be referred to as "printing structures" because in the image area, such structures receive and transfer ink to the printing substrate. Of course, in the waste areas, these structures are cut away, but they still have a height that is at or near the top of the plate, and thus may also be referred to as "printing" structures based upon the height thereof. Not shown, it is also known to make smaller mask openings that form non-printing structures raised above the floor but do not reach the top (printing height) of the plate, and thus do not transfer ink later in the printing process. Although the gaps and printing structures are shown with angled "shoulders" such as to have trapezoidal shapes, it should be understood that the angles as depicted are not to scale, nor are the relative sizes of the gaps and the cells.

Thus, as distinguished from prior art plates in which the waste areas of the fully developed plate may not have any structures at all, let alone those that rise to the printing height (top) of the plate, or for plates using the prior art solvent minimization techniques, in which the entire waste area may comprise a solid structure disposed at the top of the plate, a finished plate in accordance with aspects of the invention as disclosed herein includes solid cured areas of the plate 711 separated by gaps 720 between the solid areas. The solid cured area as depicted herein typically comprises continuous areas of printing height structure, separated only by gaps 720. By contrast, image-forming portions of modern printing plates may include solid areas that have ink-holding cells, grooves, or may otherwise comprise a plurality of spots that are separated by gaps that do not extend to the floor, for better ink holding and transfer. While such features may still be formed in the waste areas (if, for example, it would be more efficient to cover all such solid areas with such a texture via a screen than to make the waste areas different), the benefit of maximized solvent savings is achieved when no uncured areas remain, except for the designed gaps. In situations in which a texture or microdots are applied to all solid image areas using a screen, embodiments of the application as defined herein may include omitting application of that texture or microdot screen in the identified waste areas.

While it is known to provide some raised structures in an area of the plate to be later cut away, for example to form a code, such as is disclosed in, e.g., U.S. Patent No. 11,571,920, titled METHOD FOR PERSISTENT MARKING OF FLEXO PLATES WITH WORKFLOW INFORMATION AND PLATES MARKED THEREWITH, owned by the common assignee of the present invention and incorporated herein by reference, it should be understood that in embodiments of the present invention, such code, if present, may be isolated by a border of floor from the cells and discontinuities as disclosed herein, or the code may be formed as indentations (to the floor, beneath the floor, or between the floor and the top of the plate) relative to the surrounding printing-height solid area. Unlike a prior art waste area (e.g. border) portion that is otherwise all at floor height or all at printing height, in embodiments of the present invention, the majority (on a surface area basis) of the waste area comprises printing height cells defined by discontinuities at less that printing height. In most embodiments, the discontinuities form a pattern, preferably a regular repeating pattern, such as a grid.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. A process for creating a fully developed photopolymer printing plate from a photopolymer printing plate precursor, the process comprising defining one or more non-printing waste areas of the plate precursor and creating one or more areas of cured polymer covering a majority of the one or more non-printing waste areas, the one or more areas of cured polymer having a height extending above a floor of the fully-developed photopolymer printing plate to a printing level.

2. The process of claim 1, wherein the one or more areas of cured polymer comprise one or more solid cells of cured polymer and one or more discontinuities in or between the one or more solid cells of cured polymer in a defined pattern, wherein the cells of cured polymer have a height extending above a floor of the fully-developed photopolymer printing plate to the printing level and the one or more discontinuities have a height less than the printing level, wherein each of the one or more cells of cured polymer in the one or more non-printing waste regions has a cell surface area of less than or equal to a predefined value, and each of the one or more discontinuities has a discontinuity width less than or equal to a predefined value.

3. The process of claim 2, wherein a size for the one or more cells, a size for the one or more discontinuities, a pattern type for the one or more discontinuities, or a combination thereof are variables selected by a user via a user interface of a system for performing the process, optionally, wherein the one or more discontinuities define a grid of intersecting lines with rectangular cells defined therebetween, each rectangular cell having a first lateral dimension and a second lateral dimension, wherein the first lateral dimension and the second lateral dimension are user-selected variables.

4. The process of any one of claims 1 -3, wherein the plate precursor includes an image area of the plate surrounded by a border area that extends from outer edges of the image area to lateral edges of the plate, and the one or more non-printing waste areas are defined in the border region of the plate.

5. The process of any one of the foregoing claims, wherein the image area defines a plurality of plate patches to be cut from the fully-developed photopolymer printing plate.

6. The process of claim 5, further comprising one or more non-patch areas between adjacent patches in the plurality of plate patches, wherein the one or more non-printing waste areas are defined in the one or more non-patch areas between the adjacent patches in the plurality of plate patches.

7. The process of any one of claims 2-6, wherein the predefined value for the cell surface area and the predefined value for the discontinuity width are selected to reduce solvent usage in an uncured polymer removal step and to minimize deformation of the photopolymer printing plate precursor during a processing step performed after the uncured polymer removal step or to minimize plate deformation of the fully-developed photopolymer printing plate.

8. The process of claim 7, wherein the solvent used in the uncured polymer removal step is a non-water-based solvent.

9. The process of claim 7, wherein the processing step performed after the uncured polymer removal step with minimized deformation is a drying step.

10. A system for creating a fully-developed photopolymer printing plate from a photopolymer printing plate precursor having a masking layer, the masking layer configured to block actinic radiation from exposing and curing the photopolymer, the system comprising an imaging system configured to define openings in the masking layer, each opening configured to permit penetration of actinic radiation, the imaging system configured to define an image area of the photopolymer printing plate precursor having openings in the masking layer corresponding to an image to be printed, to define one or more defined non-printing waste areas of the photopolymer printing plate precursor, and then to apply in the one or more defined non-printing waste areas a pattern of openings in the masking layer in a majority of the one or more waste areas corresponding to one or more areas of cured polymer having a height extending above a floor of the fully-developed photopolymer printing plate to a printing level.

11. The system of claim 10, wherein the one or more areas of cured polymer comprise one or more solid cells of cured polymer and one or more discontinuities in or between the one or more solid cells, and the system optionally comprises a computer memory, a processor configured to execute instructions stored in the computer memory, and a user interface connected to the computer memory for receiving input from a user, the user input including cell and discontinuity information comprising a size for the one or more cells, a size for the one or more discontinuities, a pattern type for the discontinuities, or a combination thereof, optionally, wherein the user interface is configured to permit a user to select a grid pattern type, a maximum grid cell width, a maximum grid cell length, and a grid cell gap.

12. The system of claims 10 or 11, wherein the processor includes a raster image processor (RIP) and the user interface is configured to provide the cell and discontinuity user input information to image information subsequently processed by the RIP.

13. The system of any one of claims 10-12, wherein the image area defines a plurality of plate patches to be cut from the fully developed photopolymer printing plate, and one or more non-patch areas between adjacent patches in the plurality of plate patches, wherein the one or more non-printing waste areas are defined in the one or more non-patch areas between the adjacent patches in the plurality of plate patches.

14. The system of any one of claims 10-12, wherein the plate precursor includes an image area of the plate surrounded by a border area that extends from outer edges of the image area to lateral edges of the plate and the one or more non-printing waste areas are defined in the border region of the plate.

15. Non-transitory computer media programmed with machine-readable instructions readably by a processor of an imager in a system for creating a fully-developed photopolymer printing plate from a photopolymer printing plate precursor having a masking layer configured to block actinic radiation from contacting and curing the photopolymer, the imager configured to define openings in the masking layer, each opening configured to permit penetration of actinic radiation, the instructions configured to cause the imager:
(a) to define an image area of the photopolymer printing plate precursor having openings in the masking layer corresponding to an image to be printed, and
(b) to define one or more non-printing waste areas of the photopolymer printing plate precursor and applying to a majority of the one or more waste areas a pattern comprising openings in the masking layer corresponding to one or more solid areas of cured polymer, optionally with one or more discontinuities in the one or more solid areas to define a plurality of solid cells of cured polymer separated by the discontinuities, wherein the cured polymer in the one or more non-printing waste regions have a height extending above a floor of plate to a printing level and the one or more optional discontinuities have a height below the printing level, optionally wherein the machine readable instructions further include instructions for causing a user interface connected to the computer memory to receive input from a user, the user input including a size for the one or more cells, a size for the one or more discontinuities, a pattern type for the discontinuities, or a combination thereof.
